# EUROPEAN PATENT APPLICATION

(11) **EP 4 779 872 A2**
(43) Date of publication of application: **22.07.2026**
(21) Application number: 25225592.2
(22) Date of filing: 19.12.2025
(51) Int. Cl.: H03K 17/30, H03K 17/12, H03K 17/16

(54) **SYSTEMS AND METHODS FOR ADAPTIVE SWITCHING CONTROL IN POWER CONVERSION SYSTEMS**

(30) Priority: 26.12.2024 US 202463738889 P; 15.04.2025 US 202519179042
(71) Applicant: Avago Technologies International Sales Pte. Limited, Singapore 768923 (SG)
(72) Inventor: Le, Jim Kien Huy, Timnath, 80547 (US); Walley, John, Ladera Ranch, 92694 (US); Desrosiers, Ryan Michael, Fort Collins, 80528 (US)
(74) Representative: Dilg, Haeusler, Schindelmann Patentanwaltsgesellschaft mbH

(57) **Abstract**

The subject technology is directed to electronic circuits. In an embodiment, the subject technology provides an apparatus that includes a first comparator coupled to the input terminal and configured to compare an input signal to a first threshold and to generate a first signal in response to the input signal exceeding the first threshold. The apparatus further includes a first circuit coupled to the first comparator. The first circuit is configured to initiate a first interval in response to the first signal. A second comparator is configured to generate a second signal based on a comparison between the input signal and the second threshold. The first circuit is configured to adjust the first interval based on the second signal. By adaptively adjusting the control timing based on signal conditions, the apparatus enables improved switching performance and reduced conduction losses in power control applications. There are other embodiments as well.

## Description

### BACKGROUND OF THE INVENTION

Switching circuits are widely used in power conversion systems, such as rectifiers, inverters, wireless power receivers, and/or the like. These systems often rely on one or more transistors that are selectively activated to control the conduction of current or to regulate voltage levels. Accurate control of the switching behavior of such transistors is beneficial for improving power efficiency and avoiding undesirable conduction modes such as body diode conduction or reverse current flow.

In many applications, the timing of the switching event-whether turning a transistor on or off-may be based on comparisons between a monitored input signal (e.g., an AC voltage waveform) and a reference threshold. However, precise control of switching timing remains challenging due to variations in operating conditions, component tolerances, and inherent propagation delays associated with circuit components. Timing inaccuracies can lead to increased conduction losses, unwanted diode conduction, or undesired current paths. These effects become more pronounced in high-speed or high-frequency systems, where even small timing errors can significantly degrade system performance.

Various approaches have been explored to improve timing control in switching systems, but they have proven to be insufficient. It is important to recognize the need for new and improved systems and methods.

### BRIEF DESCRIPTION OF THE DRAWINGS

A further understanding of the nature and advantages of particular embodiments may be realized by reference to the remaining portions of the specification and the drawings, in which like reference numerals are used to refer to similar components. In some instances, a sub-label is associated with a reference numeral to denote one of multiple similar components. When reference is made to a reference numeral without specification to an existing sub-label, it is intended to refer to all such multiple similar components.
Figure 1 is a circuit diagram illustrating a rectifier, in accordance with various embodiments of the subject technology.
Figure 2 is a schematic diagram illustrating a timing control circuit for adaptive switching, in accordance with various embodiments of the subject technology.
Figure 3 is a timing diagram illustrating switching behavior in default mode and with adaptive turn-on control, in accordance with various embodiments of the subject technology.
Figure 4 is a circuit diagram illustrating a rectifier, in accordance with various embodiments of the subject technology.

### DETAILED DESCRIPTION

The subject technology is directed to electronic circuits. In an embodiment, the subject technology provides an apparatus that includes an input terminal configured to receive an input signal. The apparatus further includes a first comparator coupled to the input terminal and configured to compare the input signal to a first threshold and to generate a first signal in response to the input signal exceeding the first threshold. The apparatus further includes a first circuit coupled to the first comparator. The first circuit is configured to initiate a first interval in response to the first signal and to generate a control signal after the expiration of the first interval. The apparatus also includes a second comparator coupled to the input terminal. The second comparator is configured to compare the input signal to a second threshold and to generate a second signal based on a comparison between the input signal and the second threshold. The first circuit is further configured to adjust the first interval based at least on the second signal. By adaptively adjusting the control timing based on signal conditions, the apparatus enables improved switching performance and reduced conduction losses in power control applications. There are other embodiments as well.

The following description is presented to enable one of ordinary skill in the art to make and use the invention and to incorporate it in the context of particular applications. Various modifications, as well as a variety of uses in different applications, will be readily apparent to those skilled in the art, and the general principles defined herein may be applied to a wide range of embodiments. Thus, the subject technology is not intended to be limited to the embodiments presented but is to be accorded the widest scope consistent with the principles and novel features disclosed herein.

In the following detailed description, numerous specific details are set forth in order to provide a more thorough understanding of the subject technology. However, it will be apparent to one skilled in the art that the subject technology may be practiced without necessarily being limited to these specific details. In other instances, well-known structures and devices are shown in block diagram form, rather than in detail, in order to avoid obscuring the subject technology.

The reader's attention is directed to all papers and documents which are filed concurrently with this specification and which are open to public inspection with this specification, and the contents of all such papers and documents are incorporated herein by reference. All the features disclosed in this specification, (including any accompanying claims, abstract, and drawings) may be replaced by alternative features serving the same, equivalent or similar purpose, unless expressly stated otherwise. Thus, unless expressly stated otherwise, each feature disclosed is one example only of a generic series of equivalent or similar features.

Furthermore, any element in a claim that does not explicitly state "means for" performing a specified function, or "step for" performing a specific function, is not to be interpreted as a "means" or "step" clause as specified in 35 U.S.C. Section 112, Paragraph 6. In particular, the use of "step of" or "act of" in the Claims herein is not intended to invoke the provisions of 35 U.S.C. 112, Paragraph 6.

When an element is referred to herein as being "connected" or "coupled" to another element, it is to be understood that the elements can be directly connected to the other element, or have intervening elements present between the elements. In contrast, when an element is referred to as being "directly connected" or "directly coupled" to another element, it should be understood that no intervening elements are present in the "direct" connection between the elements. However, the existence of a direct connection does not exclude other connections, in which intervening elements may be present.

Moreover, the terms left, right, front, back, top, bottom, forward, reverse, clockwise and counterclockwise are used for purposes of explanation only and are not limited to any fixed direction or orientation. Rather, they are used merely to indicate relative locations and/or directions between various parts of an object and/or components.

Furthermore, the methods and processes described herein may be described in a particular order for ease of description. However, it should be understood that, unless the context dictates otherwise, intervening processes may take place before and/or after any portion of the described process, and further various procedures may be reordered, added, and/or omitted in accordance with various embodiments.

Unless otherwise indicated, all numbers used herein to express quantities, dimensions, and so forth should be understood as being modified in all instances by the term "about." In this application, the use of the singular includes the plural unless specifically stated otherwise, and use of the terms "and" and "or" means "and/or" unless otherwise indicated. Moreover, the use of the terms "including" and "having," as well as other forms, such as "includes," "included," "has," "have," and "had," should be considered non-exclusive. Also, terms such as "element" or "component" encompass both elements and components comprising one unit and elements and components that comprise more than one unit, unless specifically stated otherwise.

As used herein, the phrase "at least one of" preceding a series of items, with the term "and" or "or" to separate any of the items, modifies the list as a whole, rather than each member of the list (i.e., each item). The phrase "at least one of" does not require the selection of at least one of each item listed; rather, the phrase allows a meaning that includes at least one of any one of the items, and/or at least one of any combination of the items. By way of example, the phrases "at least one of A, B, and C" or "at least one of A, B, or C" each refer to only A, only B, or only C; and/or any combination of A, B, and C. In instances where it is intended that a selection be of "at least one of each of A, B, and C," or alternatively, "at least one of A, at least one of B, and at least one of C," it is expressly described as such.

One general aspect includes an apparatus comprising an input terminal configured to receive an input signal. The apparatus further comprises a first comparator coupled to the input terminal and configured to compare the input signal to a first threshold and to generate a first signal in response to the input signal exceeding the first threshold. The apparatus further comprises a first circuit coupled to the first comparator and configured to initiate a first interval in response to the first signal and to provide a control signal after expiration of the first interval. The apparatus further comprises a second comparator coupled to the input terminal and configured to compare the input signal to a second threshold and to generate a second signal based on a comparison between the input signal and the second threshold. The first circuit is further configured to adjust the first interval based at least on the second signal.

Implementations may include one or more of the following features. The input signal comprises an alternating current (AC) component. The apparatus further comprises a driver coupled to the first circuit and configured to receive the control signal. The apparatus further comprises a first transistor coupled to the driver, the driver being configured to activate the first transistor in response to the control signal. The apparatus further comprises a second transistor coupled in parallel with the first transistor, the second transistor being configured to be activated after the first transistor. The second threshold is greater than a reference voltage associated with a rectified output. The first circuit is configured to increase the first interval in response to the second signal indicating that the input signal is below the second threshold. The first circuit is configured to decrease the first interval in response to the second signal indicating that the input signal exceeds the second threshold. The second threshold is greater than the first threshold.

According to another embodiment, the subject technology provides an apparatus that comprises an input terminal configured to receive an input signal. The apparatus further comprises a first comparator coupled to the input terminal and configured to compare the input signal to a first threshold and to generate a first signal in response to the input signal exceeding the first threshold. The apparatus further comprises a first circuit coupled to the first comparator and configured to initiate a first interval in response to the first signal. The apparatus further comprises a second comparator coupled to the input terminal and configured to compare the input signal to a second threshold and to generate a second signal based on a comparison between the input signal and the second threshold, the second threshold being greater than the first threshold. The first circuit is further configured to adjust the first interval based at least on the second signal.

Implementations may include one or more of the following features. The apparatus further comprises a driver coupled to the first circuit, the first circuit being configured to provide a control signal to the driver after expiration of the first interval. The apparatus further comprises a first transistor coupled to the driver, the driver being configured to activate the first transistor in response to the control signal. The second threshold is greater than a reference voltage associated with a rectified output. The first circuit is configured to decrease the first interval in response to the second signal indicating that the input signal exceeds the second threshold. The first circuit is configured to increase the first interval in response to the second signal indicating that the input signal is below the second threshold.

According to yet another embodiment, the subject technology provides an apparatus, which comprises an input terminal configured to receive an input signal. The apparatus further comprises a first circuit coupled to the input terminal and configured to provide a control signal based at least on the input signal. The apparatus further comprises a driver coupled to the first circuit and configured to receive the control signal. The apparatus further comprises a first transistor coupled to the driver, the driver being configured to activate the first transistor in response to the control signal. The apparatus further comprises a second transistor coupled in parallel with the first transistor, the second transistor being configured to be activated after the first transistor. In some embodiments, the input signal comprises an alternating current (AC) component. The apparatus further comprises a first comparator coupled to the input terminal and the first circuit, the first comparator being configured to compare the input signal to a first threshold and to generate a first signal in response to the input signal exceeding the first threshold. The first circuit is configured to initiate a first interval in response to the first signal and to generate the control signal after expiration of the first interval. The apparatus further comprises a second comparator coupled to the input terminal and configured to compare the input signal to a second threshold and to generate a second signal based on a comparison between the input signal and the second threshold.

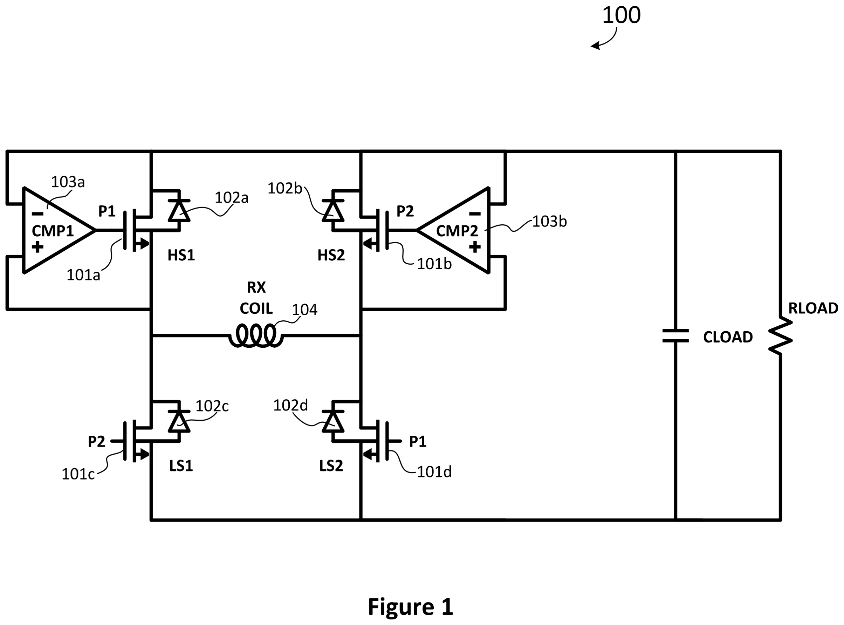

Figure 1 is a circuit diagram illustrating a rectifier 100, in accordance with various embodiments of the subject technology. This diagram merely provides an example, which should not unduly limit the scope of the claims. One of ordinary skill in the art would recognize many variations, alternatives, and modifications.

**In** various implementations, rectifier 100 may be configured to convert an input alternating current (AC) signal into a regulated direct current (DC) output voltage. Rectifier 100 may be used in a wide range of applications, such as wireless power transfer systems, power adapters, better-charging systems, power management integrated circuits (PMICs), electric vehicles, and/or the like. For example, the term "rectifier" may refer to a circuit or system configured to convert AC power into DC power. Rectifiers may be implemented using diodes, transistors, and/or other switching devices, and may be passive or actively controlled. Examples of rectifiers may include, without limitation, synchronous rectifiers, diode-based rectifiers, transistor-based rectifiers, hybrid rectifiers, and/or the like.

As an example, rectifier 100 may be configured to receive an input signal via coil 104. For instance, the term "input signal" may refer to an electrical signal that can be received and processed by an apparatus, including but not limited to, analog signals, digital signals, AC signals, DC signals, and/or the like. In some cases, the input signal may include an alternating current component. For instance, the term "alternating current" or "alternating current component" may refer to a signal that varies periodically in magnitude and/or polarity over time. For example, the input signal may originate from an external AC source and may include one or more waveform components, such as sinusoidal, triangular, square, or modulated waveforms. Rectifier 100 may be configured to convert the AC input signal into a DC output voltage (e.g., VRECT) suitable for powering downstream DC loads, such as a load capacitor (e.g., CLOAD), a load resistor (e.g., RLOAD), and/or other electronic devices or circuits.

In some embodiments, rectifier 100 may implement a full-bridge configuration, which may include one or more switching elements (e.g., transistors) arranged in a bridge layout to convert both the positive and negative halves of an AC input signal into a unified DC output voltage. For instance, rectifier 100 may include first transistor 101a (e.g., HS1), second transistor 101b (e.g., HS2), third transistor 101c (e.g., LS1), and fourth transistor 101d (e.g., LS2). For instance, the term "transistor" may refer to a semiconductor device that controls the flow of electricity in electronic circuits. Examples of transistors may include, without limitation, bipolar junction transistors (BJTs), metal-oxide-semiconductor field-effect transistors (MOSFETs), laterally-diffused metal-oxide semiconductor (LDMOS), junction field-effect transistors (JFETs), and/or the like. In some implementations, first transistor 101a and second transistor 101b may be referred to as high-side switches, and third transistor 101c and fourth transistor 101d may be referred to as low-side switches.

**In** various implementations, rectifier 100 may operate by selectively activating pairs of transistors in a complementary fashion to route both the positive and negative half-cycles of the AC input signal through a common load to produce the DC output. For instance, during a positive half-cycle of the AC input signal (e.g., the voltage at one terminal of coil 104 is higher relative to the other terminal), high-side transistor 101a (e.g., HS1) and the opposite low-side transistor 101d (e.g., LS2) may be activated to conduct current from coil 104 through the load. During the negative half-cycle (e.g., voltage polarity reversed), high-side transistor 101b (e.g., HS2) and low-side transistor 101c (e.g., LS1) may be activated to conduct the current in the opposite direction to produce a DC output voltage.

In some examples, rectifier 100 may further include one or more comparators. For instance, first comparator 103a may be coupled to first transistor 102a. Second comparator 103b may be coupled to second transistor 102b. For example, the term "comparator" may refer to an electronic device that compares two input voltages or signals and generates an output signal based on the comparison. Examples of comparators may include, without limitation, operational amplifiers, differential comparators, CMOS comparators, and/or the like. In some examples, comparators (e.g., first comparator 103a and comparator 103b) may be coupled to the gates of the high-side transistors (e.g., first transistor 102a and second transistor 102b) and configured to determine the timing of transistor activation based on monitoring voltage and/or current conditions at the coil nodes, thereby controlling the switching behavior of rectifier 100.

However, precise switching control remains challenging due to inherent delays and propagation times within the circuit, leading to short intervals during which intrinsic body diodes (e.g., diodes 102a-d) conduct unintentionally. This undesired conduction interval-which may be referred to as "diode time"-occurs when the coil node voltage surpasses the rectified DC output voltage level, yet the corresponding transistor has not fully switched on. During diode time, the body diodes become forward-biased and conduct current, introducing additional power losses characterized by diode forward voltage (e.g., Vf) multiplied by diode conduction current (e.g., Id). The body diode current also results in current through the parasitic vertical PNP device, an additional loss term characterized by the rectified DC output voltage multiplied by the parasitic collector current (e.g., Ic,pnp). These diode-related losses negatively impact overall system efficiency, especially at higher switching frequencies and higher rectified DC output voltages. Consequently, reducing diode time through improved switching control is beneficial for minimizing conduction losses and enhancing the efficiency of power conversion systems.

In various implementations, diode time may be influenced by multiple delay sources within the control path. For example, delay sources may include propagation delays associated with comparators, the latency introduced by logic circuits, level-shifting circuits, non-overlap logic (NOL), pre-driver response delays, and/or transistor gate-switching characteristics. Each of these sources may cumulatively contribute to a delay between detection of the threshold voltage condition and activation/deactivation of a transistor, thus increasing diode time. Moreover, delays may vary based on factors such as temperature, load conditions, supply voltage fluctuations, or device aging. Effectively reducing or compensating for these delays is desirable for shortening diode time and improving overall rectifier efficiency.

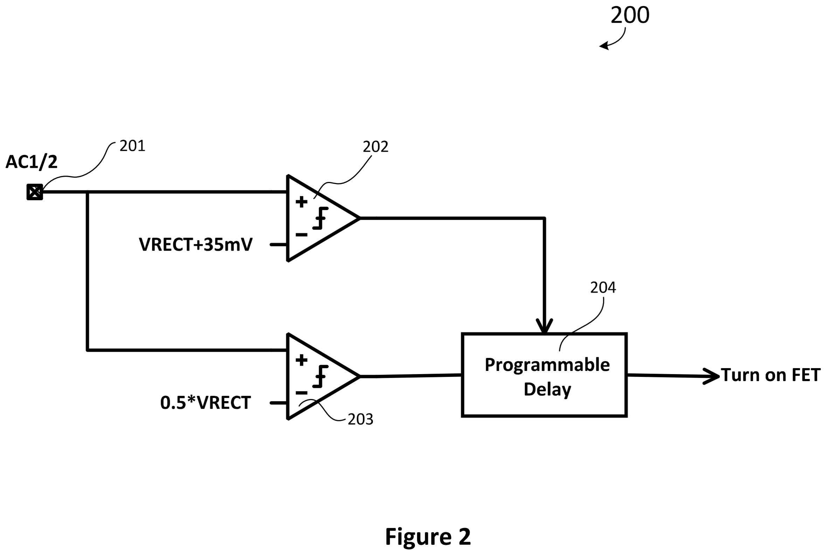

Figure 2 is a schematic diagram illustrating a timing control circuit 200 for adaptive switching, by various embodiments of the subject technology. This diagram merely provides an example, which should not unduly limit the scope of the claims. One of ordinary skill in the art would recognize many variations, alternatives, and modifications.

In some implementations, circuit 200 may be part of a rectifier system (e.g., rectifier 100 of Figure 1) and may be configured to facilitate adaptive switching control of one or more switching elements (e.g., high-side transistors) based on real-time signal conditions. For instance, the term "adaptive switching control" may refer to a control mechanism that dynamically adjusts the timing or behavior of switch activation or deactivation based on sensed or computed parameters from the system. In some examples, circuit 200 may be used to fine-tune the timing of a turn-on event or turn-off event for a power transistor in response to changes in an AC input signal, which helps reduce conduction losses and minimize diode time.

In various embodiments, circuit 200 may include input terminal 201, which may be configured to receive an input signal. For instance, the input signal received at input terminal 201 may include a portion or node voltage of an alternating current (AC) waveform, such as a coil node voltage from a rectifier circuit (e.g., rectifier 100 of Figure 1). In some cases, the input signal may exhibit periodic AC behavior and may serve as a reference for timing comparisons.

According to certain implementations, circuit 200 may further include first comparator 203 coupled to input terminal 201. For instance, first comparator 203 may be configured to compare the input signal to a first threshold and to generate a first signal in response to the input signal exceeding the first threshold. For example, the term "threshold" or "voltage threshold" may refer to a voltage level used as a comparison reference to determine a control condition. Depending on the implementation, thresholds may be fixed, programmable, or dynamically adjusted. In some examples, the first threshold may correspond to a fraction of the rectified output voltage (e.g., 0.5 * VRECT). For example, the term "rectified output voltage" or "rectified output" may refer to a DC voltage or current produced by a rectifier circuit as a result of converting an AC input signal. The rectified output may be a full-wave or partial waveform depending on the rectifier configuration. When the input signal crosses the first threshold, comparator 203 may generate the first signal to indicate a baseline switching condition.

In various examples, circuit 200 may further include first circuit 204, which may be coupled to first comparator 203. First circuit 204 may be configured to initiate a first interval in response to the first signal and to generate a control signal after the expiration of the first interval. For instance, the term "interval" or "time interval" may refer to a predefined or programmable period of time that elapses between two events, such as between the detection of a signal threshold crossing and the generation of a subsequent control signal. Depending on the implementation, the first interval may be fixed, programmable, or dynamically adjusted based on real-time operating conditions. In some examples, the first interval may be used to align control actions-such as turning a transistor on or off-with optimal circuit conditions to reduce conduction losses, compensate for inherent latencies (e.g., diode time), or avoid premature switching. For example, the first interval may account for propagation delays, pre-driver response time, and/or transient behavior in power devices. In some cases, the first interval may be implemented using digital counters, analog delay circuits, programmable delay lines, state machines, and/or the like.

According to some embodiments, circuit 200 may further include second comparator 202, which may be coupled to input terminal 201. Second comparator 202 may be configured to compare the input signal to a second threshold and to generate a second signal based on a comparison between the input signal and the second threshold. In some cases, the second threshold may be greater than a reference voltage associated with a rectified output (e.g., VRECT). The term "reference voltage" may refer to a voltage level used as a baseline or comparison point in signal processing. For example, the second threshold may correspond to a voltage slightly above the rectified output voltage (e.g., VRECT+35 mV), which may be used to detect the onset of unwanted body diode conduction.

When the input signal exceeds the second threshold, second comparator 202 may generate a signal indicating the timing of diode conduction. In some cases, the second signal may be provided to first circuit 204 as feedback to modify the first interval. For instance, first circuit 204 may be configured to increase the first interval in response to the second signal indicating that the input signal is below the second threshold (e.g., suggesting delayed diode conduction). In other aspects, first circuit 204 may be configured to decrease the first interval in response to the second signal indicating that the input signal exceeds the second threshold (e.g., suggesting early diode conduction).

In various embodiments, the adjustment of the first interval may be implemented using different techniques, such as linear scaling based on the amplitude of the second signal, non-linear mapping functions, predefined adjustment values stored in a look-up table, and/or the like. The adjustment process may account for a variety of real-time or historical parameters, which may include, without limitation, the magnitude and rate of change of the second signal, historical patterns in comparator activity, system temperature, load current, supply voltage, overall power demand, and/or the like.

In some implementations, the control signal generated by first circuit 204 upon expiration of the first interval may be employed to selectively activate or deactivate switching elements, such as turning on or off transistors, MOSFETs, or other semiconductor devices in rectifier circuits, DC-DC converters, or other power conversion systems. For instance, the control signal may be provided to gate drivers, transistor gate terminals, or pre-driver circuits to coordinate device switching with real-time signal conditions.

In certain embodiments, one or more comparators (e.g., first comparator 203 and/or second comparator 202) may be configured with adjustable propagation delay characteristics. For example, a comparator (e.g., first comparator 203 and/or second comparator 202) may support configurable propagation delay by modifying internal bias current levels. In some aspects, predictive timers or slower comparators may be employed to adjust the bias current in anticipation of imminent switching events. For instance, when the input signal voltage approaches a switching threshold-such as a fraction of the rectified output voltage (e.g., VRECT/2)-the comparator bias current may be increased, thereby lowering propagation delay and improving responsiveness immediately before the switching event. Subsequently, after completion of the switching event, the bias current may be reduced to increase propagation delay and minimize power consumption. This enables rapid response when needed while preserving energy during idle periods or steady-state operation. Depending on the implementation, this dynamic configuration may be controlled based on predetermined conditions, real-time voltage thresholds, or historical switching patterns, and can be applied to both turn-on and turn-off transitions.

In some implementations, circuit 200 may perform real-time calibration of one or more thresholds (e.g., the first threshold and/or the second threshold). For example, voltage thresholds used for early switching can be periodically calibrated in real-time by initially setting the comparator threshold slightly above the output voltage (e.g., approximately 100 mV above the rectified output voltage) and then gradually lowering this threshold until the comparator no longer triggers prematurely. Additionally, the comparator (e.g., first comparator 203 and/or second comparator 202) may be duty-cycled to conserve power, since continuous monitoring during every switching cycle may not be necessary. Such threshold calibration and power-saving comparator operation schemes can further enhance switching performance and efficiency.

It is to be appreciated that the adaptive switching control mechanism implemented by circuit 200 enables dynamic adjustment of the switching timing of power transistors or other switching elements based on real-time circuit conditions. By modifying timing intervals in response to threshold comparisons, circuit 200 adaptively adjusts the timing of transistor activation to preemptively compensate for expected delays associated with diode conduction intervals (e.g., diode time), thereby optimizing the overall efficiency of power conversion systems. In some implementations, such adaptive adjustment may be performed across multiple switching cycles, allowing circuit 200 to converge toward an ideal timing point and to continuously fine-tune the delay in response to changing operating conditions, such as load variations, temperature shifts, or component aging.

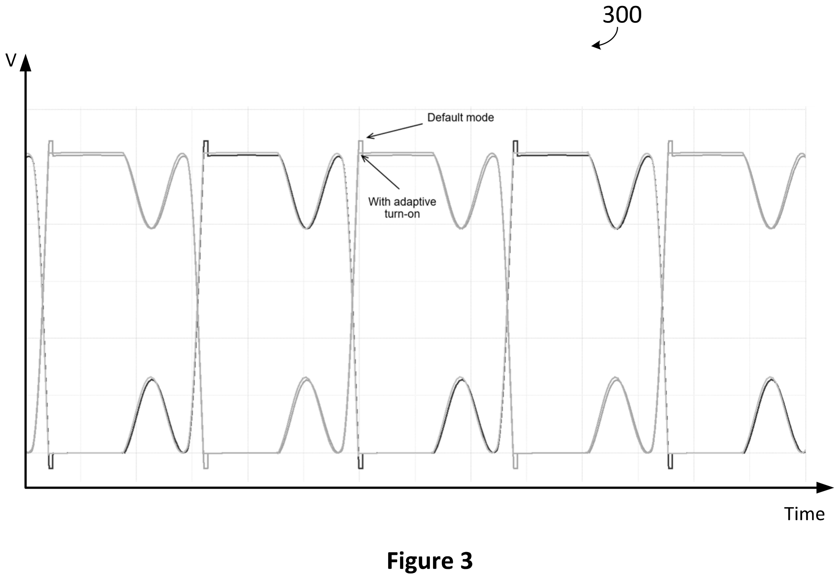

Figure 3 is a timing diagram 300 illustrating switching behavior in default mode and with adaptive turn-on control, in accordance with various embodiments of the subject technology. This diagram merely provides an example, which should not unduly limit the scope of the claims. One of ordinary skill in the art would recognize many variations, alternatives, and modifications.

In various implementations, timing diagram 300 depicts voltage waveforms associated with the switching behavior of a power conversion system (e.g., rectifier 100 of Figure 1) operating under different control schemes. For instance, timing diagram 300 illustrates waveforms under: (1) a default switching mode with a fixed delay or control threshold; and (2) an adaptive switching mode based on the adaptive timing control mechanism (e.g., implemented by circuit 200 of Figure 2). The vertical axis represents voltage (V), and the horizontal axis represents time.

In some embodiments, the default mode waveform may indicate switching events occurring at fixed time intervals relative to threshold crossings. Due to these fixed intervals, switching may not optimally align with the actual circuit conditions, resulting in periods of unintended diode conduction (e.g., diode time). As shown, the default mode switching events may lead to a small peak in the output waveform just before the main transition. This peak may be indicative of brief conduction through the body diode prior to the activation of the corresponding power transistor, which introduces additional power losses and degrades efficiency.

In contrast, the adaptive turn-on mode improves switching performance by dynamically adjusting switching intervals based on real-time threshold comparisons. By shortening or extending the switching intervals in response to detected conditions, the adaptive control substantially reduces or eliminates diode conduction intervals, enhancing the overall efficiency and performance of the circuit. In some cases, adaptive switching control may repeat over multiple cycles, incrementally fine-tuning the timing intervals to compensate for varying conditions, such as component variations, temperature fluctuations, load changes, device aging, and/or the like.

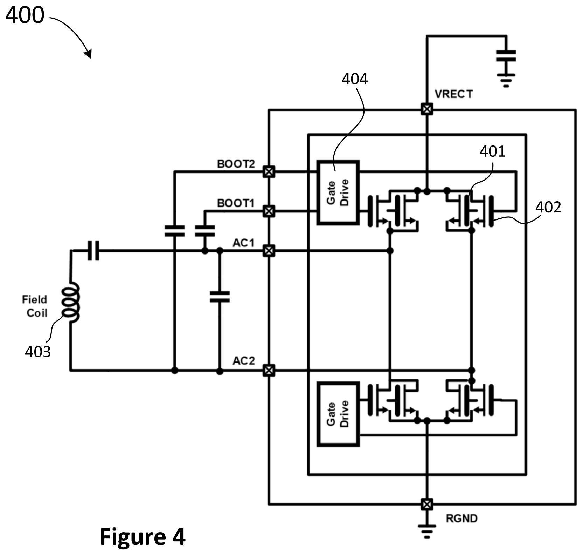

Figure 4 is a circuit diagram illustrating a rectifier 400, in accordance with various embodiments of the subject technology. This diagram merely provides an example, which should not unduly limit the scope of the claims. One of ordinary skill in the art would recognize many variations, alternatives, and modifications.

In various implementations, rectifier 400 may be configured to receive an AC input signal via coil 403 and convert the AC signal into a rectified DC output voltage (e.g., VRECT). In some examples, coil 403 may be coupled to input terminals (e.g., AC1 and AC2), which may serve as the input nodes for rectifier 400. The rectified output voltage may be provided to a downstream load through an output terminal (e.g., VRECT).

In various implementations, rectifier 400 may further include one or more drivers (e.g., driver 404) configured to control the activation of switching transistors. For instance, the term "driver" or "gate driver" may refer to a circuit that provides the necessary voltage and/or current to switch a power transistor (e.g., MOSFET) between its conducting (e.g., on) and nonconducting (e.g., off) states. Examples of drivers may include, without limitation, level shifters, pre-drivers, charge pumps, and/or the like. In some examples, drivers (e.g., driver 404) may receive a control signal from a comparator or timing control circuit (e.g., circuit 200 of Figure 2) and generate appropriate drive signals for the gates of the corresponding transistors. For instance, the term "control signal" may refer to an electrical signal that conveys timing, activation, or configuration instructions to a circuit. The control signal may be implemented in various forms, such as voltage pulses, current pulses, digital logic signals, analog voltage levels, pulse-width modulated (PWM) signals, and/or the like.

As an example, a control signal may be generated when a comparator detects that an AC coil node voltage (e.g., AC1) exceeds a threshold value, triggering a delay circuit (e.g., first circuit 204 of Figure 2) to time the optimal switching point. In some aspects, the control signal may be adjusted based on predictive estimations of future switching events or on feedback indicating early or delayed conduction.

In some embodiments, rectifier 400 may implement a parallel-transistor configuration to improve switching performance. For instance, rectifier 400 may include first transistor 401 and second transistor 402 arranged in parallel between common input and output nodes. In some examples, first transistor 401 and second transistor 402 may have different electrical characteristics, such as transistor sizing, gate capacitance, channel width, on-resistance (Ron), and/or the like. For instance, first transistor 401 may have a relatively smaller transistor size or fewer transistor fingers, resulting in lower gate capacitance and faster switching speed but higher on-resistance. In some cases, first transistor 401 may be referred to as a small transistor or a fast-switching transistor. Conversely, second transistor 402 may have a relatively larger transistor size or a higher number of transistor fingers, leading to a lower on-resistance and improved conduction performance but slower switching due to larger gate capacitance. In some cases, second transistor 402 may be referred to as a large transistor or high-conduction transistor. In some implementations, first transistor 401 may be activated initially to quickly initiate conduction and reduce diode conduction losses, followed by activation of second transistor 402 to provide lower-resistance conduction and optimize overall efficiency.

In some examples, rectifier 400 may employ an adaptive control mechanism to selectively activate first transistor 401 and second transistor 402 at different times based on real-time voltage or current conditions at the input terminals (e.g., AC1 and AC2). For instance, a timing control circuit (e.g., circuit 200 of Figure 2) may detect an input signal crossing a predefined threshold and generate a control signal to activate first transistor 401. Based on additional feedback or real-time monitoring of input signals, the timing control circuit may determine when to activate second transistor 402. By sequencing the activation of the transistors adaptively in response to circuit conditions, rectifier 400 may reduce switching delay and minimize diode time. In some embodiments, the adaptive control mechanism may also be used to control turn-off events, allowing the small transistor (e.g., first transistor 401) to disengage first to suppress ringing or overshoot before fully turning off the power path.

While the above is a full description of the specific embodiments, various modifications, alternative constructions and equivalents may be used. Therefore, the above description and illustrations should not be taken as limiting the scope of the subject technology which is defined by the appended claims.

## Claims

1. An apparatus comprising:
an input terminal configured to receive an input signal;
a first comparator coupled to the input terminal and configured to compare the input signal to a first threshold and to generate a first signal in response to the input signal exceeding the first threshold;
a first circuit coupled to the first comparator and configured to initiate a first interval in response to the first signal; and
a second comparator coupled to the input terminal and configured to compare the input signal to a second threshold and to generate a second signal based on a comparison between the input signal and the second threshold;
wherein the first circuit is further configured to adjust the first interval based at least on the second signal.

2. The apparatus of claim 1, wherein
the input signal comprises an alternating current, AC, component.

3. The apparatus of claim 1 or 2, further comprising
a driver coupled to the first circuit,
wherein the driver is configured to receive the control signal
and/or
wherein the first circuit is configured to provide a control signal to the driver after expiation of the first interval.

4. The apparatus of claim 3, further comprising
a first transistor coupled to the driver, the driver being configured to activate the first transistor in response to the control signal.

5. The apparatus of claim 4, further comprising
a second transistor coupled in parallel with the first transistor, the second transistor being configured to be activated after the first transistor.

6. The apparatus of any one of the preceding claims, wherein
the second threshold is greater than a reference voltage associated with a rectified output.

7. The apparatus of any one of the preceding claims, wherein
the first circuit is configured to increase the first interval in response to the second signal indicating that the input signal is below the second threshold.

8. The apparatus of any one of the preceding claims, wherein
the first circuit is configured to decrease the first interval in response to the second signal indicating that the input signal exceeds the second threshold.

9. The apparatus of any one of the preceding claims, wherein
the second threshold is greater than the first threshold.

10. An apparatus comprising:
an input terminal configured to receive an input signal;
a first circuit coupled to the input terminal and configured to provide a control signal based at least on the input signal;
a driver coupled to the first circuit and configured to receive the control signal;
a first transistor coupled to the driver, the driver being configured to activate the first transistor in response to the control signal; and
a second transistor coupled in parallel with the first transistor, the second transistor being configured to be activated after the first transistor.

11. The apparatus of claim 10, wherein
the input signal comprises an alternating current, AC, component.

12. The apparatus of claim 10 or 11, further comprising
a first comparator coupled to the input terminal and the first circuit, the first comparator being configured to compare the input signal to a first threshold and to generate a first signal in response to the input signal exceeding the first threshold.

13. The apparatus of claim 12, wherein
the first circuit is configured to initiate a first interval in response to the first signal and to generate the control signal after expiration of the first interval.

14. The apparatus of any one of the claims 10 to 13, further comprising
a second comparator coupled to the input terminal and configured to compare the input signal to a second threshold and to generate a second signal based on a comparison between the input signal and the second threshold.
